# EUROPEAN PATENT SPECIFICATION

(11) **EP 0 668 714 B1**
(45) Date of publication and mention of the grant of the patent: **25.10.2000**
(21) Application number: 94112499.2
(22) Date of filing: 10.08.1994
(51) Int. Cl.: H05K 7/18, H05K 9/00

(54) **Rack apparatus, for containing electric components therein, having improved shielding function**
Baugruppenträger zur Aufnahme von elektrischen Bauteilen mit einer Abschirmungsfunktion
Baie contenant des composants électrique ayant une fonction de blindage

(30) Priority: 17.02.1994 JP 2063494
(43) Date of publication of application: 23.08.1995
(73) Proprietor: FUJITSU LIMITED, Kawasaki-shi, Kanagawa 211 (JP)
(72) Inventor: Hayashi, Hisao, c/o Fujitsu Limited, Kawasaki-shi, Kanagawa 211 (JP); Yamaji, Hiroshi, c/o Fujitsu Limited, Kawasaki-shi, Kanagawa 211 (JP); Takahashi, Tsutomu, c/o Fujitsu Limited, Kawasaki-shi, Kanagawa 211 (JP); Sakiura, Jun, c/o Fujitsu Limited, Kawasaki-shi, Kanagawa 211 (JP)
(74) Representative: Ritter und Edler von Fischern, Bernhard, Dipl.-Ing.

(56) References cited:
- EP-A- 0 319 909
- DE-A- 3 633 209
- DE-U- 8 417 517
- FR-A- 2 571 922
- FR-A- 2 651 386
- US-A- 5 015 802

## Description

### BACKGROUND OF THE INVENTION

### 1. Field of the Invention

The present invention relates to a rack apparatus, in particular to a rack apparatus used as an equipment used in a communication system. In the rack apparatus, a plurality of box-shaped electronic circuit blocks are arranged in a row on a holding column having shelves formed thereon for holding the electronic circuit blocks.

Recently, electronic circuits have high-frequency and high-density have been developed and, as a result, leaking of electromagnetic waves is a problem regarding such electronic circuits. In order to prevent such a problem, there has been an increased demand for rack apparatuses having an improved shielding capability for shielding electronic circuits from electromagnetic waves.

### 2. Prior Art

With respect to FIGS.1 and 2, a conventional rack apparatus 10 disclosed in Japanese Patent Publication No.2-60118 will now be described.

The rack apparatus 10 is located in a local-station building and includes a vertically standing holding column 11 having a plurality of electronic circuit blocks 12 screwed thereon, the electronic circuit blocks 12 being arranged in a row. Since the holding column 11 has been grounded, the holding column 11 shields electric cables 11c contained in the holding column 11 from electromagnetic waves, the cables 11c electrically connecting electronic circuits provided in the electronic circuit blocks 12.

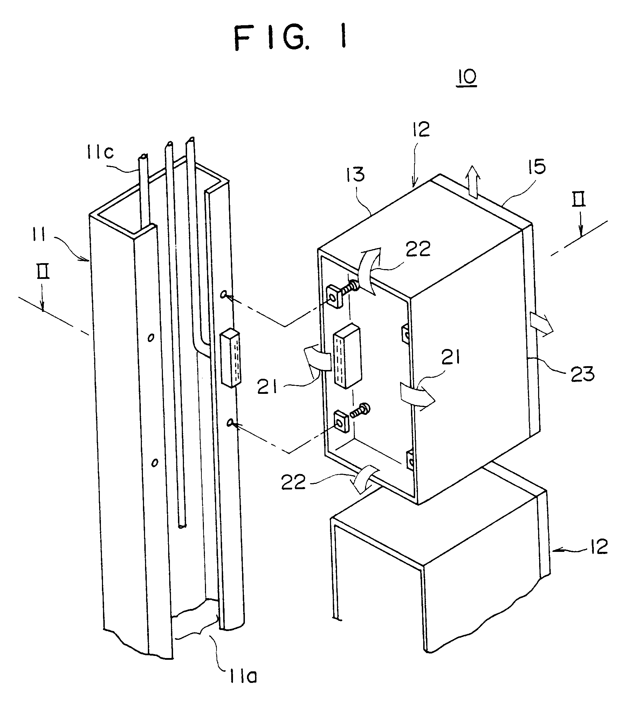

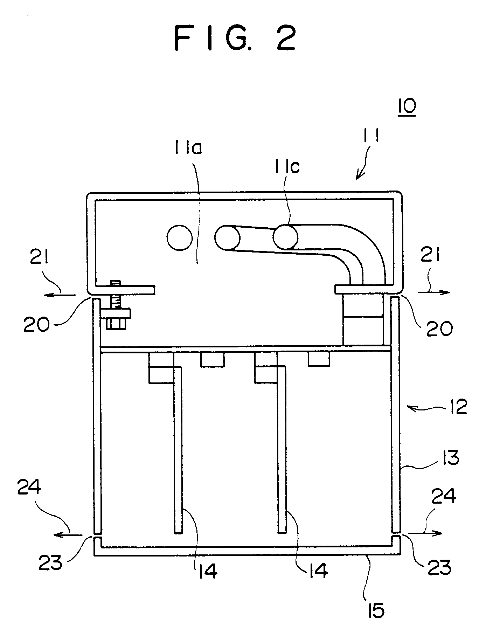

Each of the electronic circuit blocks 12 includes a box 13 containing electronic circuit packages 14 (electronic components loaded on print circuit boards) as shown in FIG.2 and also includes a lid 15 for closing the front of the box 1 as shown in FIG.1.

However, the conventional rack apparatus 10 has the following problems regarding its electromagnetic-wave shielding capability.

With regard to the rear face of the electronic circuit block 12, the following problematic construction is present. As shown in FIG.2, rear edges of the box 13 touch merely small areas of the front surfaces of the holding column 11. Thus, gaps 20 are likely to be present between rear edges of the box 13 and front surfaces of the holding column 1. As a result, the electric potential of the box 13 may be different from the electric potential of the holding column 11. Therefore, it is likely that electromagnetic waves will leak from the electronic circuit block 13 through the gaps 20 in side directions 21 shown in FIGS.1 and 2.

Further, as shown in FIGS.1 and 2, an opening 11a is formed in the front of the holding column 11. As a result, electromagnetic waves may leak from the rear of the electronic circuit block 13 through the opening 11a, the thus leaking electromagnetic waves then passing in upward and downward directions 22 through the inside space of the holding column 11 as shown in FIG.1.

With regard to the front face of the electronic circuit block 12, since the lid 15 is mounted on the box 13 ordinarily without any special provision, slight gaps 23 are likely to be present between the lid 15 and the box 13. As a result, the electric potential of the box 13 may be different from the electric potential of the lid 15. Therefore, it is likely that electromagnetic waves will leak from the electronic circuit block 13 through the gaps 23 in side directions 24 shown in FIGS.1 and 2.

Thus, due to the insufficient connection between components in the rack apparatus of the prior art, such as the above rack apparatus 10 sufficient shielding capability is not provided.

FR-A-2 651 386 also shows a rack apparatus.

### SUMMARY OF THE INVENTION

An object of the present invention is to provide a rack apparatus having improved shielding capability.

In order to achieve the above object of the present invention, a rack apparatus according to the present invention is provided, the apparatus characterized in that the holding member (holding column) comprises overlaying portions with which side walls of each container (electronic circuit block) are overlaid.

The overlaying portions prevents gaps from being formed between the holding column and electronic circuit blocks, electromagnetic waves thus being prevented from leaking from the electronic circuit blocks.

The above rack apparatus is further characterized in that either the overlaying portions or the plurality of containers comprise an elastic member for elastically pressing the other members.

The elastic member ensures electric connection of the overlaying portions with the side walls of the electronic circuit blocks.

Further, the elastic member comprises a plurality of leaf-spring elements, the elements being respectively curved and arranged in a row. As a result, each leaf-spring element can act as an individual leaf spring acting to press the other object of the rack apparatus to ensure that the elastic member achieves a uniform electric connection between the holding column and the electronic circuit blocks along the entire extent of the area where both-side objects (column and blocks, in this example) meet each other. By using the individually acting leaf-spring elements, even if differences from designed configurations are inevitable in the configurations of the objects such as the column or the blocks, as the free ends of all the leaf-spring elements come into contact with the objects such as the holding column and circuit blocks without fail. Thus, the shielding capability is improved.

Further, the holding member comprises a body having the plurality of containers mounted thereon and a covering member for covering the body and said overlaying portions. Such a construction enables a holding column manufactured in accordance with a conventional design such as the holding column 11 shown in FIGS.1 and 2 to be used as a part of the rack apparatus according to the present invention as a result of using such a conventional-design holding column as the main body of the holding member and another member such as the covering member being provided thereon. Since the covering member which is electric conductive comes into contact with the holding column and also with the electronic circuit blocks, the electric potential of the holding column is substantially the same as the electric potential of the electronic circuit blocks. Thus the shielding capability of the rack apparatus is improved.

Further, the above holding member is provided with supporting attachments fixed on the above body for supporting the overlaying portions. As the supporting attachments reinforce the overlaying portions, the overlaying portions are prevented from being deformed, which deformation would prevent sufficient electric connection between the holding column and electronic circuit blocks. Thus, reliability of the overlaying portions can be improved.

The holding member is formed of a single piece of material. Thus, the holding column has a simple construction and can be manufactured in a simple manufacturing process. Thus, the rack apparatus can be an economical one.

Further, the rack apparatus is preferably characterized in that the holding member has brackets projecting therefrom, the plurality of containers being mounted on the holding member so that adjacent containers sandwich each of the brackets. Either the brackets or the plurality of containers preferably comprise an elastic member for elastically pressing the other objects of the rack apparatus. The elastic member comprises a plurality of leaf-spring elements, the elements being curved and arranged in a row. Thus, gaps present between adjacent electronic circuit blocks can be covered and thus electromagnetic-wave leaking from the blocks can be prevented.

Further, each of the plurality of containers typically has a box shape and includes a box and a lid, either the box or the lid having an elastic member for elastically pressing the other member. The elastic members prevent gaps from being formed between the box and lid, thus preventing electromagnetic waves from leaking from the container.

Further, the rack apparatus further comprises a blank container for filling a space formed between two containers among the plurality of containers. The blank container prevents an opening from being formed among the containers, thus preventing electromagnetic waves from leaking from the containers.

Other objects and further features of the present invention will become more apparent from the following detailed description when read in conjunction with the accompanying drawings.

### BRIEF DESCRIPTION OF THE DRAWINGS

FIG.1 shows an exploded perspective view of a rack apparatus in the prior art;
FIG.2 shows an enlarged cross sectional view of the above rack apparatus shown in FIG.1 taken along a line II-II;
FIG.3 shows an exploded perspective view of a rack apparatus in a first embodiment of the present invention;
FIG.4 shows an external perspective view of the rack apparatus shown in FIG.3;
FIG.5 shows an enlarged cross-sectional view of the rack apparatus shown in FIG.4 taken along a line V-V;
FIG.6 shows an enlarged cross-sectional view of the rack apparatus shown in FIG.4 taken along a line VI-VI;
FIG.7A shows enlarged cross-sectional views of the rack apparatus shown in FIG.4 taken along a line VII-VII;
FIG.7B shows a variant of the construction shown in FIG.7A.
FIG.8A shows a partially cut-away side-elevational view of an electronic circuit block 35 shown in FIG.3 from a direction XIII;
FIG.8B shows an enlarged view of a part enclosed by a circle VIIIB of the view shown in FIG.8A;
FIG.8C shows an enlarged view of a part enclosed by a circle VIIIC of a view shown in FIG.8D;
FIG.8D shows a variant of the construction shown in FIG.8A;
FIG.9 shows an enlarged partial perspective view of side wall 55 of the electronic circuit block separated from a leaf-spring member 65 shown in FIG.3:
FIG.10 shows an enlarged assembled partial cross-sectional view of the side wall 55 and the leaf-spring member 65 shown in FIG.9;
FIG.11 shows an enlarged partial side-elevational view of a lid member 53 being set on a box body 52 of the electronic circuit block;
FIG.12 shows an enlarged cross-sectional view of the rack apparatus shown in FIG.4 taken along a line XII-XII;
FIG.13 shows an enlarged partial cross-sectional view of a side wall 54, a front plate portion 40d of a holding column 31, an overlaying portion 41b-1 and the leaf-spring member 65, constituting a shielding construction 90 provided between the electronic circuit block 35 and the holding column 31 shown in FIG.5;
FIG.14 shows an enlarged partial cross-sectional view of the side wall 54 of a box body 52, the lid member 53 and the leaf-spring member 65, constituting a shielding construction 100 provided between the box body 52 and the lid member 53 shown in FIG.5;
FIG.15 shows an enlarged partially cut-away partial side-elevational view of the electronic circuit blocks 35 and 36 and the holding column 31 of a part 120 of the rack apparatus, shown in FIG.4 from a direction XV;
FIG.16 shows an enlarged partial longitudinal sectional view of a bottom plate 57 of the electronic circuit block 35, a top plate 56 of the electronic circuit block 36 and a holding column body 40 of the holding column 31, constituting a shielding construction 121 provided among the electronic circuit blocks and holding column shown in FIG.15;
FIG.17 shows an enlarged partially cut-away partial side-elevational view of a blank block 37 and the electronic circuit block 35 of the rack apparatus similar to the rack apparatus shown in FIG.4, illustrating a shielding construction formed of the blank block 37;
FIG.18 shows an enlarged cross-sectional view of a rack apparatus in a second embodiment of the present invention;
FIG.19 shows an embodiment of a shielding construction obtained as a result of modifying the shielding construction shown in FIG.13;
FIG.20 shows an embodiment of a shielding construction obtained as a result of modifying the shielding construction shown in FIG.14; and
FIG.21 shows an embodiment of a shielding construction obtained as a result of modifying the shielding construction shown in FIG.16.

### DESCRIPTION OF THE PREFERRED EMBODIMENTS

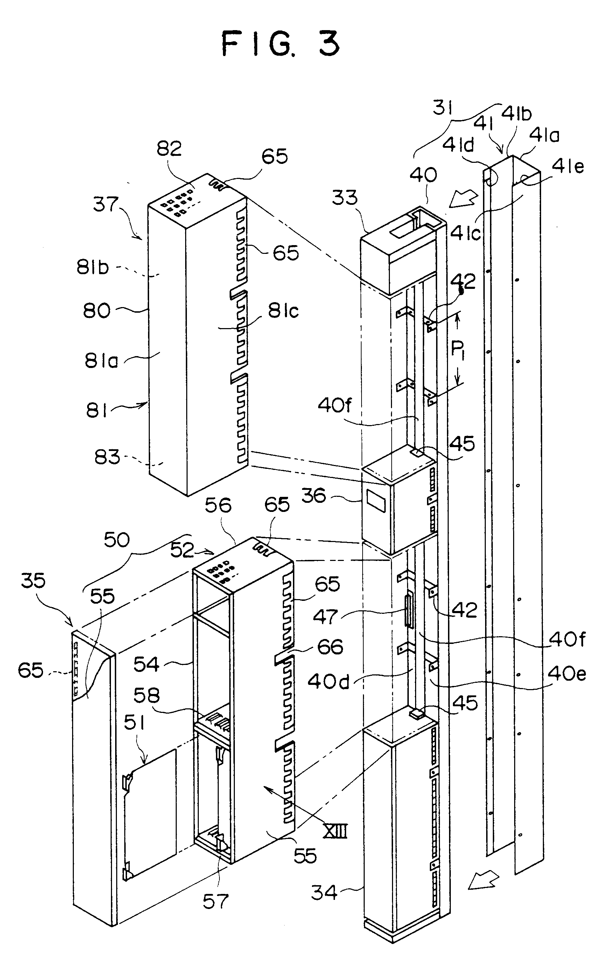

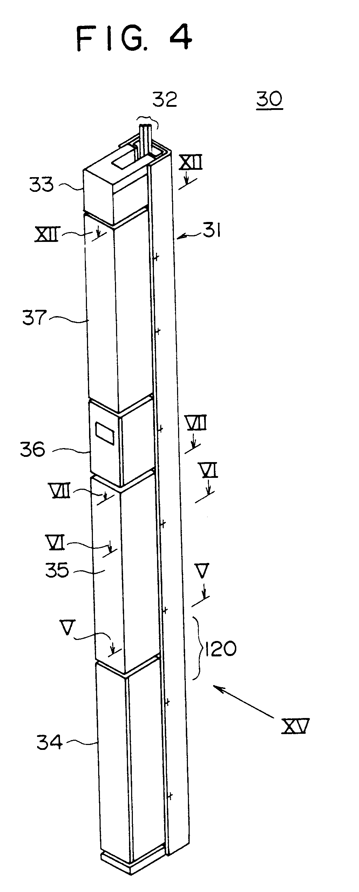

A rack apparatus 30 in a first embodiment of the present invention will now be described. As shown in FIGS.3 and 4, the rack apparatus 30 has a construction obtainable as a result of modifying the rack apparatus in the related art.

The bottom of the rack apparatus 30 is fixed on a floor and the top of the rack apparatus 30 is fixed on a ceiling of a local-station building. The rack apparatus 30 includes a vertically standing holding column 31, electric cables 32 shown in FIG.4 vertically laid inside the holding column 31, and a power distribution unit 33 provided at the top of the holding column 3.

The rack apparatus 30 further includes first, second and third electronic circuit blocks 34, 35 and 36 and a blank block 37.

The first electronic circuit block 34 is mounted on the holding column 31 at a position near the bottom of the apparatus 30 as shown in the figures. The second electronic circuit block 35 is mounted on the holding column 31 above the first electronic circuit block 34. The third electronic circuit block 36 is mounted on the holding column 31 above the second electronic circuit block 35. The blank block 37 is also mounted on the holding column 31 so as to fill a space formed between the power distribution unit 33 and the third block 36, thus preventing electromagnetic waves from leaking from the rack apparatus. As shown in the figures, the first electronic block 34, second electrical circuit block 35, third electronic circuit block 36, blank block 37 and power distribution block 33 are vertically arranged in a straight row.

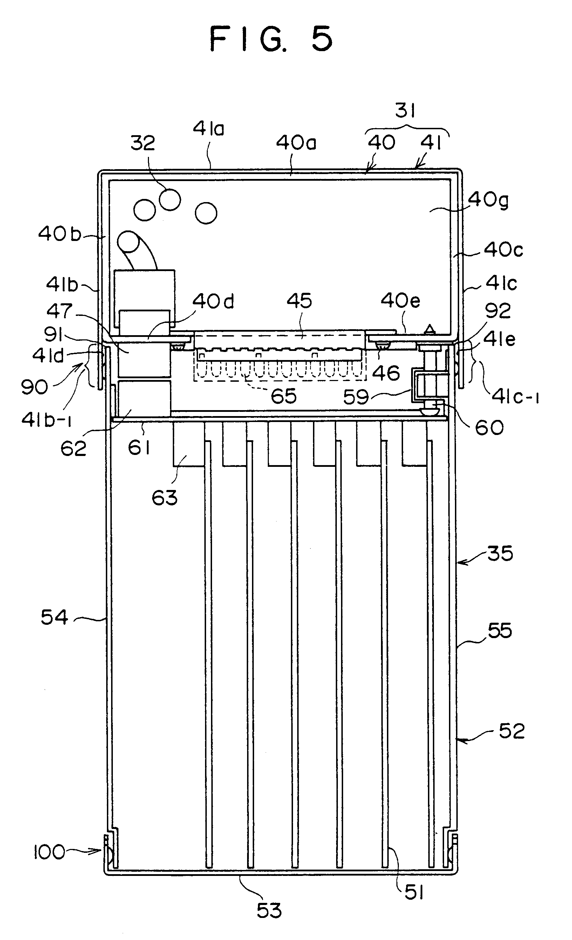

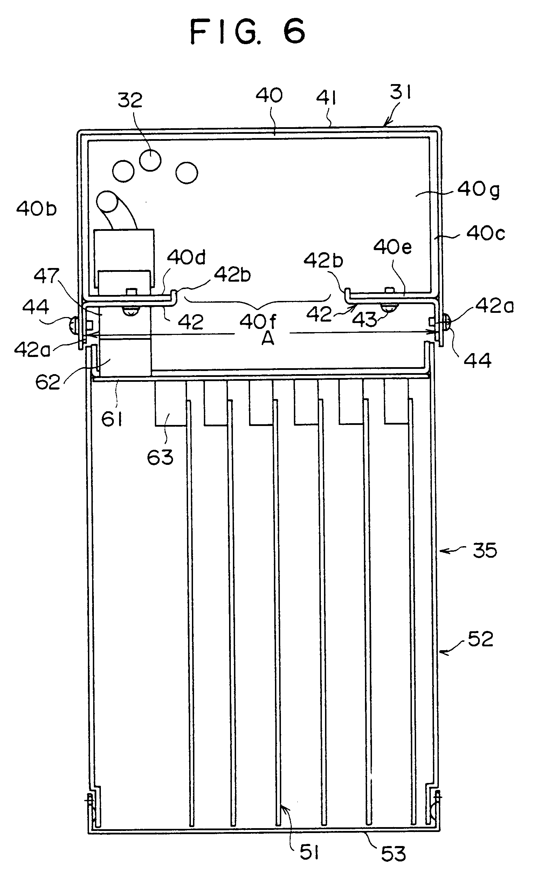

The construction of the holding column 31 will now be described. As shown in FIG.5, the holding column 31 includes a column body 40 and a shielding reinforcing member 41 which covers the rear and side walls of the column body 40. The column body 40 is formed of a strip-shaped iron plate having an approximately 2-mm thickness coated with melamine resin or the like. The column body 40 is formed as a result of bending the iron plate so as to obtain a cross section of approximately a C-shape. As a result, the column body 40 includes a rear plate portion 40a, mutually opposing side plate portions 40b and 40c, and a left front plate portion 40d and a right front plate portion 40e. As shown in FIG.5, the front plate portions 40d and 40e extend so as to approach in a direction each other from the front ends of the side plate portions 40b and 40c. The front plate portions 40d and 40e extend along the holding column 31 at the front thereof and act as surfaces on which the blocks 34, 35, 36, and 37 area placed. An opening 40f is formed between the front plate portions 40d and 40e as shown in FIG.6. A space 40g is formed inside the holding column 31 and contains the cables 32 passing therethrough as shown in FIG.6.

A shielding reinforcing member 41 is formed as a result of bending both of the sides of a strip-shaped iron plate having an approximately 2-mm thickness at right angles and galvanized. The shielding reinforcing member 41 includes a rear plate portion 41a and side plate portions 41b and 41c located on the two sides of the rear plate portion 41a. Each of the side plate portions 41b and 41c has a length longer by several tens mm than the respective side plate portions 40b and 40c of the column body 40. This length difference results in front-edge parts of the side plate portions 41b and 41c projecting from the front surfaces of the front plate portions 40d and 40e as shown in FIG.5 after the column body 40 is fitted into the shielding reinforcing member 41, as will be described later. The front-edge parts of the side plate portions 41b and 41c are referred to as overlaying portions 41b-1 and 41c-1, as shown in the figure. Melamine resin is coated on all the surface of the shielding reinforcing member 41 excepting the inside of the overlaying portions 41b-1 and 41c-1 of the side plate portions 41b and 41c, the inside of the overlaying portions 41b-1 and 41c-1 being galvanized. These galvanized portions are referred to as exposed surface portions 41d and 41e, as shown in the figure. As shown in the figure, the shielding reinforcing member 41 is provided on the rear and the side walls of the column body 40 so as to cover therewith the walls of the column body 41. Thus, the inner surface of the shielding reinforcing member 41 comes into closely contact with the outer surface of the column body 40 so as to come into capacitive contact with the column body 40. The close fitting of the shielding reinforcing member 41 with the column body 40 causes the electric potential of the column body to be the same as the electric potential of the electronic circuit blocks 34, 35 and 36 as a result of the blocks being mounted on the column body 40. It is insured that the column body 40 and the electronic circuit blocks 34, 35, and 36 have the same electric potential as a result of the above-mentioned exposed surface portions 41d and 41e coming into contact with the blocks 34, 35 and 36.

As shown in FIGS.3 and 6, metallic bracket members 42 are mounted on the front plate portions 40d and 40e of the column body 40 so that there is an approximately uniform interval P₁ formed between the bracket members in each pair of adjacent brackets members 42. The two ends of each bracket member 42, a front end portion 42a and a rear end portion 42b, are L-shaped as shown in the figures. The bracket members 42 are screwed on the front plate portions 40d and 40e with screws 43 so that the rear end portions 42b come into contact with the edges of the front plate portions 40d and 40e. The front end portions 42a of the bracket members 42 are screwed onto the overlaying portions 41b-1 and 41c-1 with screws 44 so that the shielding reinforcing member 41 is closely fixed to the column body 40 as described above. As shown in FIG.6, the screwing of the front end portions 42a of the bracket members 42 onto the overlaying portions 41b-1 and 41c-1 of the side plate portions 41b and 41c results in the inner surfaces of the overlaying portions 41b-1 and 41c-1 extending along the outer surfaces of the front end portions 42a. Thus, the bracket members 42 reinforce the overlaying portions 41b-1 and 41c-1 so that the space, shown in FIG.6, between the insides of the overlaying portions 41b-1 and 41c-1 is made to be an accurate predetermined length A. Further, this space is maintained although the overlaying portions 41b-1 and 41c-1 are outwardly pressed after the electronic circuit blocks 34, 35 and 36 have been mounted on the holding column 31 as shown in FIG.5.

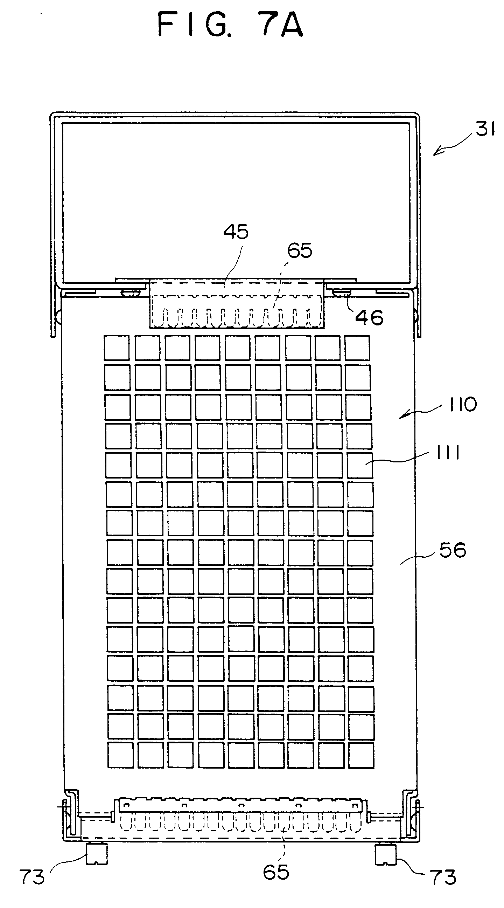

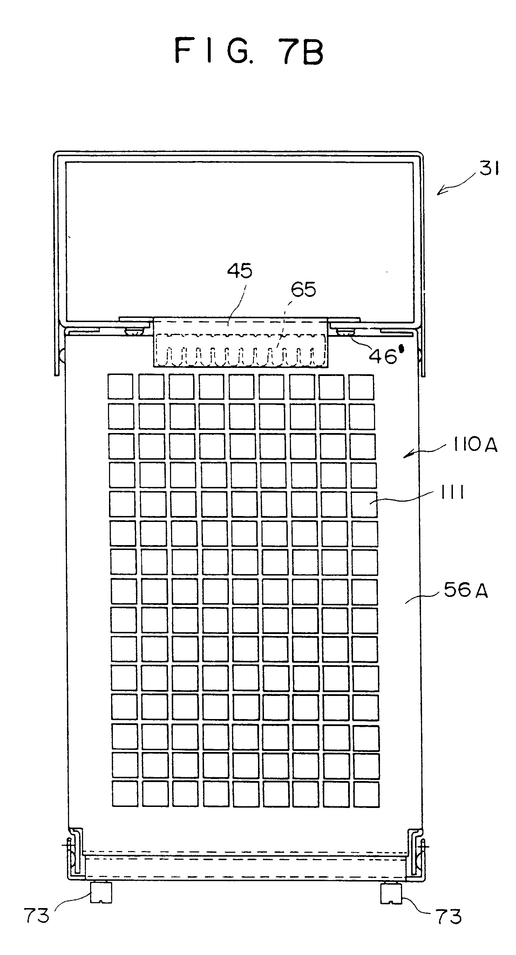

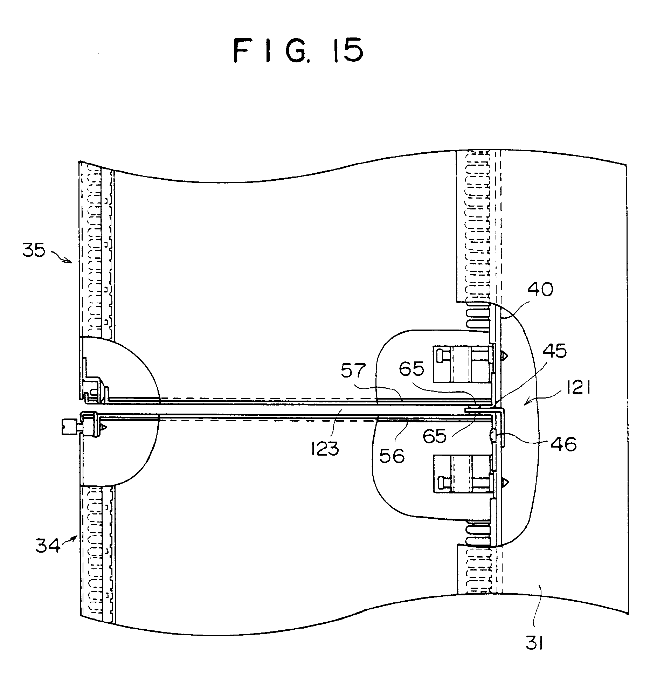

Further, as shown in FIGS.3 and 15, another sort of bracket members 45 are fixed on the column body 40, between the electronic circuit blocks 34 and 35, between the electronic circuit blocks 35 and 36, between the electronic circuit block 36 and blank block 37, and between the blank block 37 and the power distribution unit 33. As shown in FIGS.5 and 7, the bracket members 45 are screwed on the front plate portions 40d and 40e of the column body 40, to extend across a space present between the left front plate portion 40d and the right front plate portion 40e, and frontwardly project through an opening 40f from the column body 40.

Further, as shown in FIG.5, connectors 47 are mounted on the front plate portion 40d of the column body 40.

The second electronic circuit block 35 will now be described with reference to FIGS.3, and 5 through 11.

As shown in FIGS.3 and 5, the second electronic circuit block 35 includes a metallic cubic-shaped box 50 containing a plurality of electronic circuit packages 51 having been inserted from the front of a boxy body 52 into a plurality of connectors 63 mounted on a back board 51 of the box 50. Each of the electronic circuit packages 51 is a printed circuit board having many electronic components loaded thereon. The box 50 includes the above-mentioned rectangular box body 52 and a lid member 53 provided on the front of the box body 52. The box body 52 has side plates 54 and 55 on its two sides, a top plate 56, a bottom plate 57 and a shelf plate 58 inside the box body 52, as shown in FIG.3. As shown in FIG.5, the box body 52 is provided at its rear side with a bracket 59 for supporting a screw 60 and the above-mentioned back board 61. The front side of the back board 61 is provided with the above-mentioned plurality of connectors 63 and the left end of the rear side of the board 61 is provided with another connector 62, as shown in FIG.5.

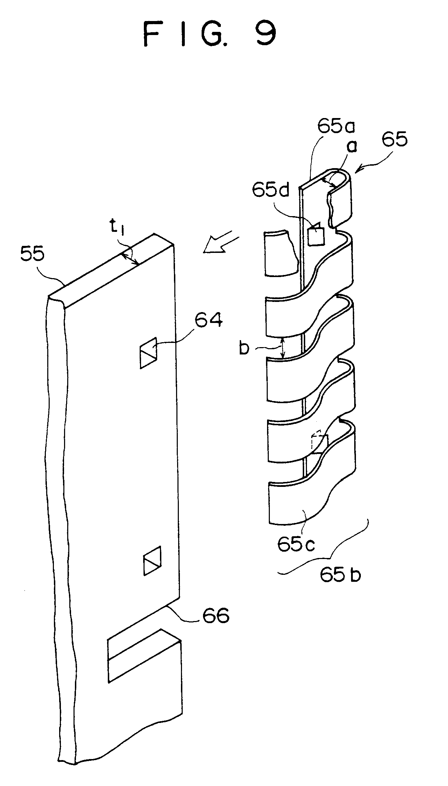

As shown in FIGS.3 and 9, cut-out portions 66 and holes 64 are formed on the side plates 54 and 55 at positions near the rear edges thereof. The cut-out portions 66 engage with the front end portions 42a (shown in FIG.6) of the bracket members 42 and the holes 64 engage with raised cut portions 65d of an electrically conductive leaf-spring member 65 shown in FIG.9. As shown in FIG.3, the leaf-spring members 65 are mounted on the rear edges of the side plates 54 and 55 so as to cover the entire area of the rear edges excepting the cut-out portions 66. Such leaf-spring members 65 are used to ensure shielding capability of the rack apparatus.

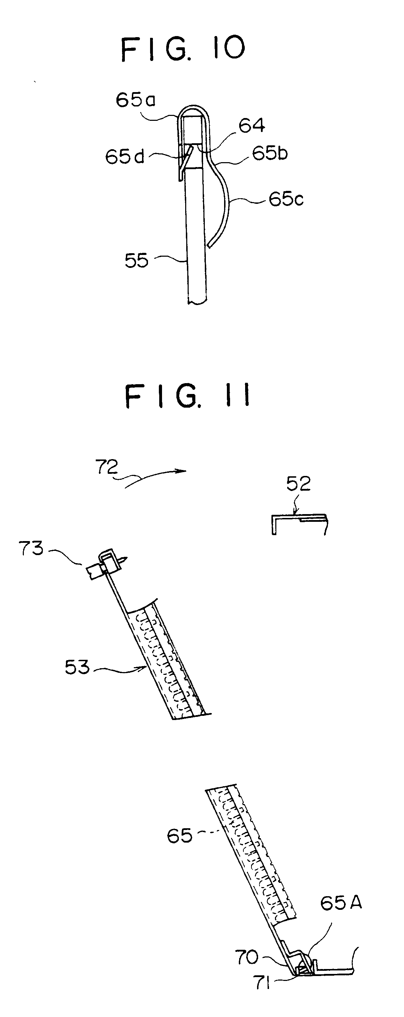

The leaf-spring members 65 will now be described with reference to FIG.9. Each of the leaf-spring members 65 includes a U-shaped body portion 65a and a plurality of free-end portions 65b, each free-end portion 65b extending from the U-shaped body portion 65a. The free-end portions 65b are arranged in a row in the longitudinal direction of the body portion 65a so as to be elastically transformable, that is, so that each free end portion can act as an individual leaf spring. Each of the free-end portions 65b includes an arc-shaped portion 65c at the extending edge thereof. Further, the above-mentioned raised cut portions 65d are formed in the body portion 65a as a result of cutting portions in the body portion 65a and raising the cut portions toward the free-end portions 65b. As shown in FIG.10, the leaf-spring member 65 is mounted on the rear edge of the side plate 55 so that the body portion 65a and the free-end portions 65b sandwich the rear edge of the side plate 55 and the cut raised portions 65d engage with the holes 64 of the side plate 55. As a result, the free-end portions 65b are arranged in a row on the outside of the side plate 55 as shown in FIG.3. Similar leaf-spring members 65 are mounted on the rear edge of the side plate 54.

Further, as shown in FIGS.3, 5, 7, and 15, similar leaf-spring members 65 are mounted on the rear edges of the top plate 56 and bottom plate 57 of the box body 52 in the respective middle portions thereof.

The box 50 is, as shown in FIG.5, screwed onto the front plate portion 40e of the holding column 31 by the above-mentioned screw 60. The connector 62 of the electronic circuit block 35 is connected with a connector 47 provided on the holding column 31.

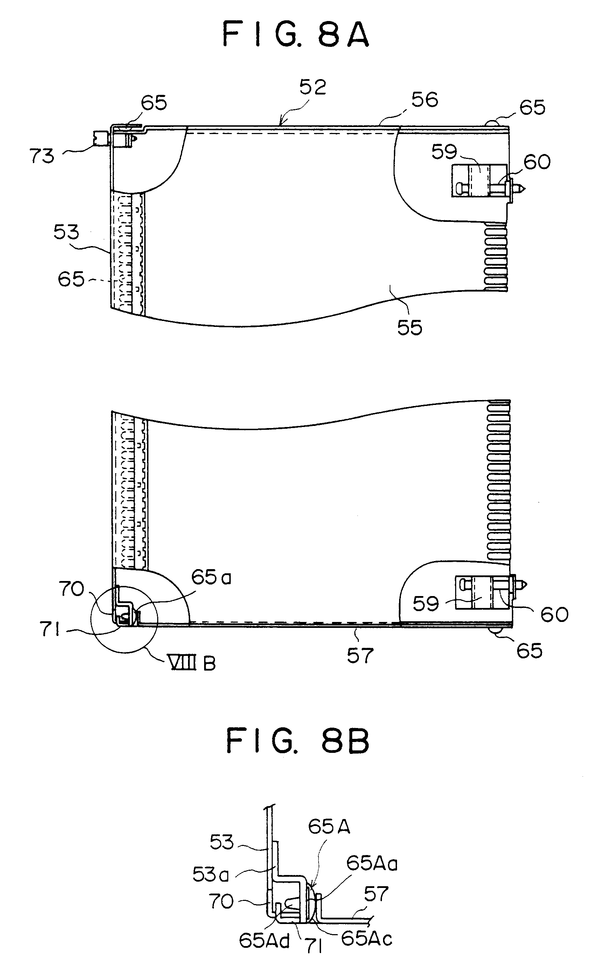

Further, as shown in FIGS.7A, 8A and 8B, a first type of leaf-spring members 65, similar to the leaf-spring members 65 shown in FIG.9, and a second type of leaf-spring member 65A are provided at the edge parts of the lid member 53. The second type of leaf-spring member 65A is mounted on the bottom edge of the lid member 53 as shown in FIGS.8A and 8B. Similar to the construction of the first type of the leaf-spring member 65 shown in FIG.9, the second type of leaf-spring member 65A has a shape having arc-shaped portions 65Ac and a body portion 65Aa. The basic functions by which the body portion of the leaf-spring member is fixed on a first object and so that a second object adjacent to the first object is pressed by the arc-shaped portions of the leaf-spring member are the same for the two types of the leaf-spring member 65 and 65A. However a specific method for fixing the body portion of the leaf-spring member of the first type on the first object differ from that for the second type. The portions 65Ac and 65Aa of the second type have different shapes from the portions 65c and 65a of the first type of the leaf-spring member 65 due to the above difference in the specific fixing methods. The second type of leaf-spring member 65A is fixed on the lid member 53 via an appropriate attachment member 53a directly fixed on the lid member 53. The body portion 65Aa, which has a plane shape, of leaf-spring member 65A is fixed on the attachment member 53a via plastic rivets 65Ad inserted into holes formed in the attachment member 53a. The horizontal width of the first type of leaf-spring member 65 fixed on the top edge of the lid member 53 is to short as shown in FIG.7A that screws 73 are provided to enable the lid member 53 to be screwed onto the top plate 56 of the box body 52 as shown in FIG.8A.

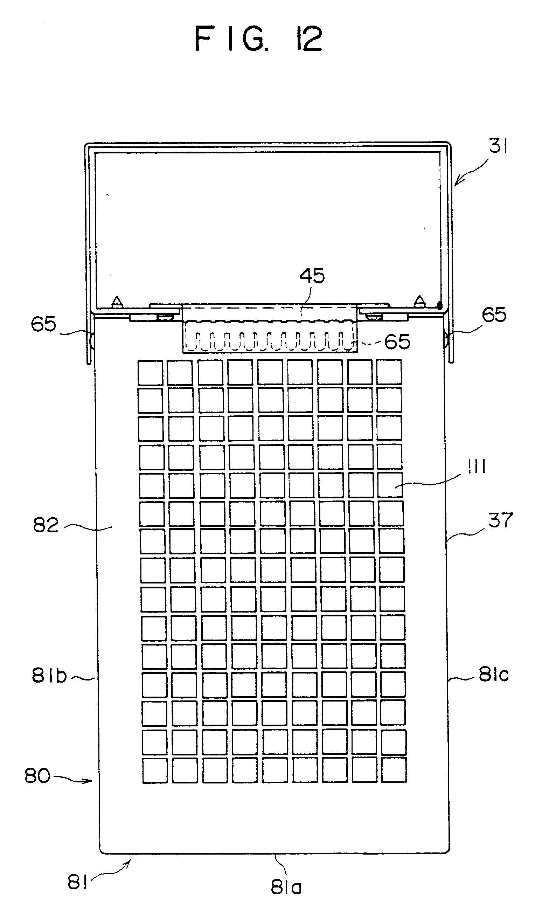

In FIG.11, an indication of a part of the top edge of the lid member 53 and a part of the front edge of the top plate 56 is omitted, the omitted parts relevant to the leaf spring member 65 and indicated in FIG.8A.

As shown in FIG.11, an engaging hole 70, formed at the bottom of the lid member 53, engages with an engaging piece 71 formed at the front-bottom of the box body 52. Thus, the lid member 53 is rotatably supported on the box body 52. Rotating the lid member 53 in a direction indicated by an arrow 72 shown in the figure results in the lid member 53 closing the front opening of the box body 52. After rotating of the lid member 53 has resulted in the front opening of the box body 52 being closed, the screw 73 provided at the top of the lid member 53 shown in FIG.11 is screwed into a screw hole formed on the front-top of the box body 52 so that the lid member 53 is fastened onto the box body 52. Electromagnetic shielding between each of the four edges of the lid member 53 and the box body 52 is ensured by using the leaf-spring members 65 and 65A therebetween as described above.

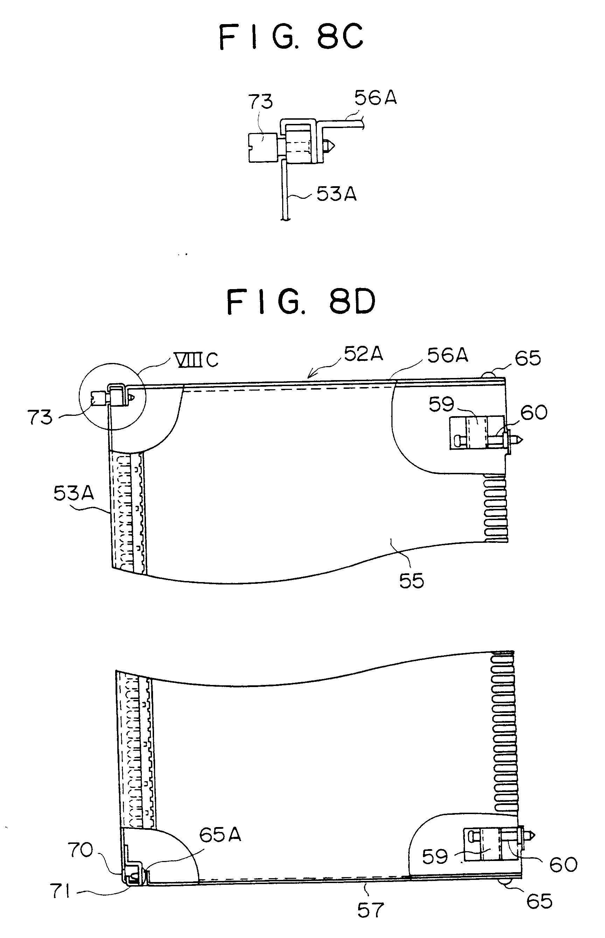

A variant of the construction according to the present invention shown in FIGS.7A, 8A and 8B will now be described with reference to FIGS.7B, 8C and 8D. Those elements in FIGS.7B, 8C and 8D substantially identical to the elements in the construction shown in FIGS.7A, 8A and 8B are given the same reference numerals as those given the latter elements and description thereof is omitted. Further, those elements in the variant which have the suffix 'A' attached to their respective reference numerals have constructions basically similar to corresponding elements in FIGS.7A, 8A and 8B, and relevant features of elements in the variant which differ from the corresponding elements in FIGS.7A, 8A and 8B will be described. In the variant, the lid member 53A has a construction by which a top edge thereof is connected with the front edge of a top plate 56A by using the screws 73 to screw the lid member 53A onto the top plate 56A along the entire length of the top edge so that no gap is present between the top edge of the lid member 53A and the top plate 56A. Thus, the portion at which the top edge of the lie member 53a is connected with the front edge of the top plate 56A is electromagnetically shielded.

The above description with reference to FIG.11 can also be applied to the above variant. In the construction shown in FIG.8D for the above variant, the top edge of the lid member 53A is bent and the front edge of the top plate 56 is bent so that a surface of the lid member 53A faces the surface of the top plate 56 at the front-top edge of the electronic circuit block, as shown in FIG.8D.

The first electronic circuit block 34 has a construction the same as the above-described construction of the second electronic circuit block 35.

The blank block 37 will now be described with reference to FIGS.3 and 12. The blank block 37 has configuration the same as that of the second electronic circuit block 35 but contains no electronic circuit packages, thus being empty. The blank block 37 includes a box 80 and leaf-spring members 65 similar to the leaf-spring member 65 shown in FIG.9, the leaf-spring members 65 being mounted on the rear edge of the box 80 as shown in FIG.12. The blank block 37 is, in a manner similarly to that used to screw the above electronic circuit block 35, screwed onto the holding column 31. The box 80 is formed as a result of a top plate 82 and a bottom plate 83 being welded onto a U-shaped sheet metal member 81 having a front plate portion 81 and two side plate portions 81b and 81c on the two sides thereof as shown in FIG.12.

Shielding constructions in the rack apparatus 30 having the above-described electronic circuit blocks 34 and 35 and the blank block 37 mounted therein will now be described.

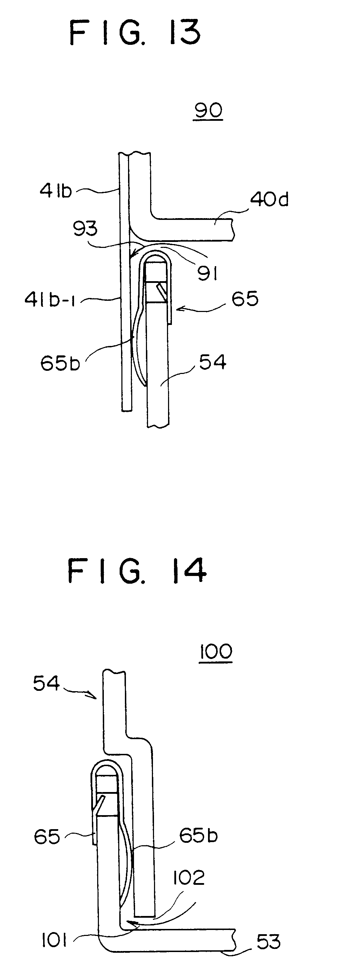

First, a shielding construction 90 between the electronic circuit block 35 and holding column 31, which is grounded, will be described. As shown in FIG.5, the rear edge of the electronic circuit block 35 is inserted between the overlaying portions 41b-1 and 41c-1 of the shielding reinforcing member 41. As a result, as shown in FIG.13, the free-end portions 65b of the leaf spring members 65 are elastically deformed so that the arc shapes of the arc-shaped portions 65c are straightened. Thus, gaps 91 and 92 formed between the column body 40 and the side plate 54 and 55 of the electronic circuit block 35 shown in FIG.5 are covered by the overlaying portions 41b-1 and 41c-1. Further, the free-end portions 65b of the leaf-spring members 65 elastically press the exposed surface portions 41d and 41e of the overlaying portions 41b-1 and 41c-1 in front of the gaps 91 and 92 as described above. Thus, the side plate 54 is electrically connected with the leaf-spring member 65 which is electrically connected with the shielding reinforcing member 41 (including the side plate portion 41b, rear plate portion 41a and side plate portion 41c being electrically connected together). The shielding reinforcing member 41 is electrically connected with leaf-spring member 65 which is electrically connected with the side plate 55. Accordingly, electrical connection of the box body 52 of the electronic circuit block 35 with the shielding reinforcing member 41 included in the grounded holding column 31 is insured. Thus, the box body 52 of the electronic circuit block 35 is surely grounded.

Thus, as shown in FIG.13, even if electromagnetic waves, generated in the electronic circuit block 35 pass through the gap 91 in a direction indicated by an arrow 93, the waves are blocked by the free-end portion 65b of the leaf-spring member 65, thus preventing the waves from leaking from the block 35. Similar electromagnetic-wave blocking is performed for the gap 92 located at the opposite side shown in FIG.5 through the relevant free-end portion 65b of the leaf-spring member 65.

Each interval b between adjacent free-end portions 65b shown in FIG.9 is predetermined to be so small as to prevent electromagnetic waves from leaking therethrough.

Further, since each fee-end portion 65b is individually elastically deformable and the overlaying portions 41b-1 and 41c-1 are mechanically reinforced so as to be prevented from being bent outwardly as described above, elastic contact of each free-end portion 65b with the overlaying portions 41b-1 and 41c-1 is ensured. As a result, the reliability of the shielding construction is improved.

A shielding construction 100 between the box body 52 and lid member 53 will now be described. The leaf-spring members 65 are mounted on the entire periphery of the edge portions of the lid member 53, as described above. The free-end portions 65b of the leaf-spring members 65 press the side plates 54 and 55, top plate 56 and the bottom plate 57 of the electronic circuit block so that the entire periphery of the lid member 53 is electrically connected with the box body 52. As a result, even if electromagnetic waves generated in the electronic circuit block 35 pass through a gap 101 between the lid member 53 and box body 52 in a direction indicated by an arrow 102 as shown in FIG.14, the electromagnetic waves are blocked by the free-end portion 65b pressing the box body 52. Thus, the electromagnetic waves are prevented from leaking from the electronic circuit block 35.

A shielding construction between the top plate 56 and bottom plate 57 of the box 50 will now be described. As shown in FIG.7A, many holes 111 are formed in the top plate 56. These holes are arranged in a matrix and used for radiation. The size of each hole 111 is predetermined to be so small as to prevent electromagnetic waves from leaking therethrough. Thus, electromagnetic-wave leakage through the top plate 56 is prevented. The bottom plate 57 has a construction the same as the above described construction of the top plate 56. Thus, electromagnetic-wave leakage through the bottom plate 57 is also prevented.

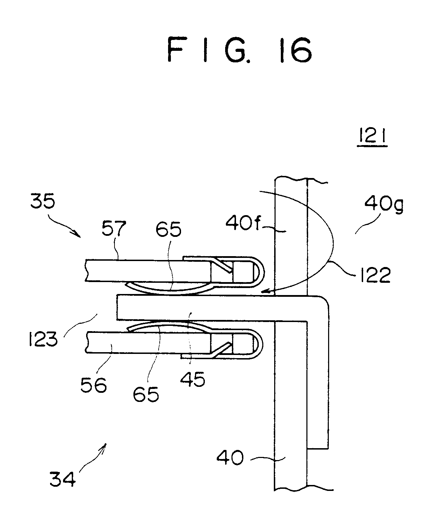

A shielding construction 121 between the first and second electronic circuit blocks 34 and 35 shown in FIG.4 will now be described. As shown in FIG.15, the leaf-spring member 65 mounted on the bottom plate 57 of the second electronic circuit block 35 elastically presses the top surface of the bracket 45. Further, the leaf-spring member 65 mounted on the top plate 56 of the first electronic circuit block 34 elastically presses the bottom surface of the same bracket 45. Thus, electrical connection of the bottom plate 57 of the second electronic circuit block 35 and the top plate 56 of the first electronic circuit block 34 with the column body 40 via the relevant leaf-spring members 65 and the bracket 45 is insured. As shown in FIG.16, even if electromagnetic waves generated in the electronic circuit block 34 exit from the block 34 to pass through the opening 40f into the space 40g in the column body 40, these waves are prevented from leaking into a gap 123 between the two electronic circuit blocks 34 and 35 by the relevant leaf-spring member 65 elastically pressing the bracket 45.

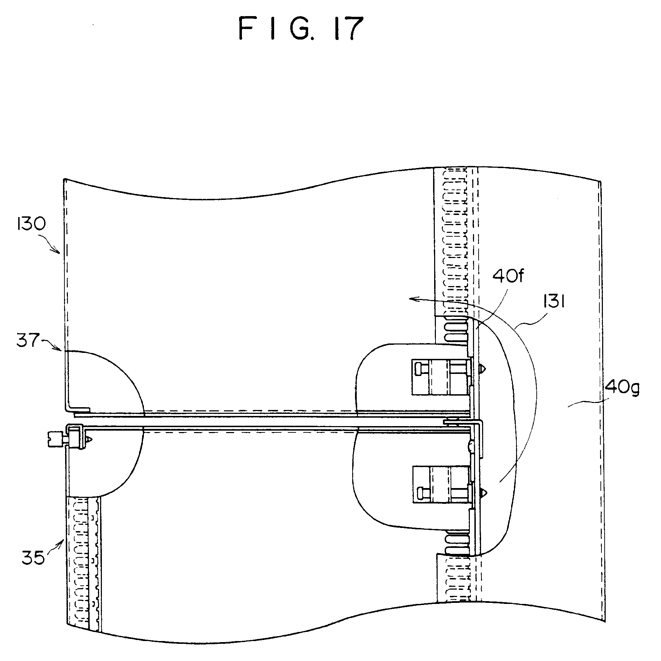

A shielding construction 130 obtained due to the blank block 37 will now be described. For the sake of simplicity, the blank block 37 is assumed to be located immediately above the second electronic circuit block 35, as shown in FIG.17. Even if electromagnetic waves leak through the rear end of the electronic circuit block 35 to pass through the opening 40f located above the circuit block 35 into the space 40g in the column body 40, as indicated by an arrow 131 in FIG.17, the electromagnetic waves are blocked by the blank block 37, thus being prevented from leaking outside the blank block 37.

After an experiment was performed so as to measure electromagnetic waves leaking from the rack apparatus 30 in the first embodiment of the present invention, it was confirmed that the leaking electromagnetic-wave level was reduced by an approximately 15 dB than in the case where the same experiment was performed for the rack apparatus 10 in the prior art shown in FIG.1. Thus, it was provided that the rack apparatus 30 according to the present invention has shielding capability superior to that of the rack apparatus 10 in the prior art.

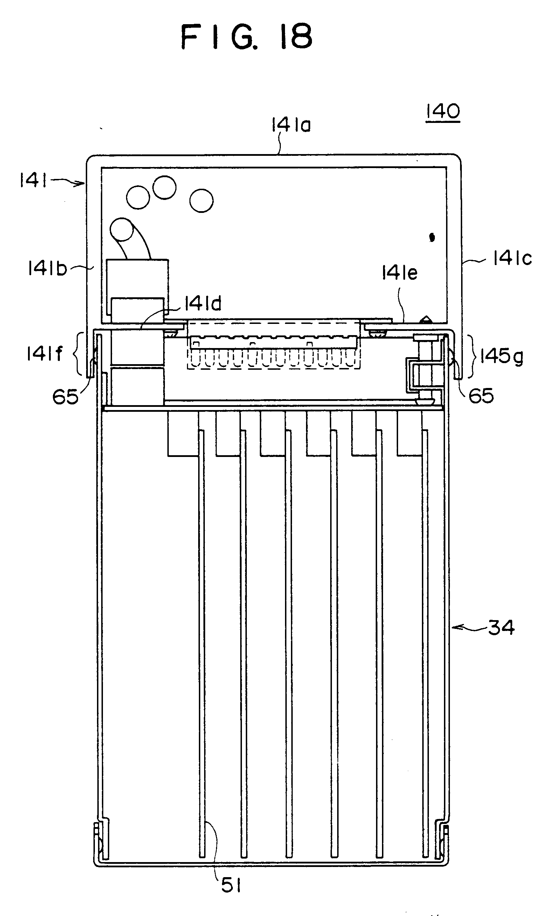

A rack apparatus 140 in a second embodiment of the present invention will now be described with reference to FIG.18. The rack apparatus 140 has a construction the same as the above-described construction of the rack apparatus 30 in the first embodiment, except that a holding column 141 has a construction different from the construction of the holding column 31 of the rack apparatus 30. The holding column 141, formed through a well-known extrusion process, includes a rear surface column portion 141a, side plate portions 141b and 141c, and front plate portions 141d and 141e, as shown in FIG.18. The holding column 141 further includes overlaying portions 141f and 141g. All the portions of the holding column 141 are formed of aluminum by a single extrusion process in this example and integrated into the holding column 141. Similar to the rack apparatus 30, the electric potential of the holding column 141 can be maintained to be the same as the electric potential of the electronic circuit block 34 as a result of being electrically connected with the block 34. Accordingly, the rack apparatus 140 has a shielding capability similar to the shielding capability of the rack apparatus 30.

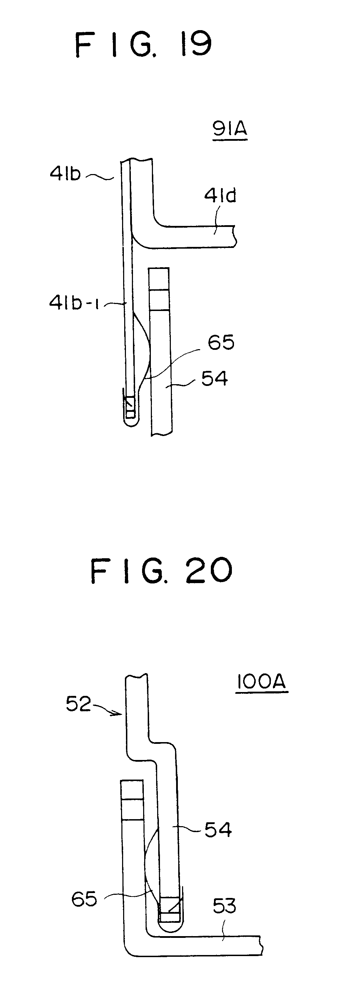

An example of a shielding construction 91A obtained as a result of modifying the shielding construction 90 shown in FIG.13 will now be described with reference to FIG.19. In this example, instead of mounting the relevant leaf-spring member 65 on the side plate 54 of the electronic circuit block, the leaf-spring member 65 is mounted on the overlaying portion 41b-1. The two shielding constructions 90 and 91A have similar effects.

An example of a shielding construction 100A obtained as a result of modifying the shielding construction 100 shown in FIG.14 will now be described with reference to FIG.20. In this example, instead of mounting the relevant leaf-spring member 65 on the lid member 53 of the electronic circuit block, the leaf-spring member 65 is mounted on the side plate 54. The two shielding constructions 100 and 100A have similar effects.

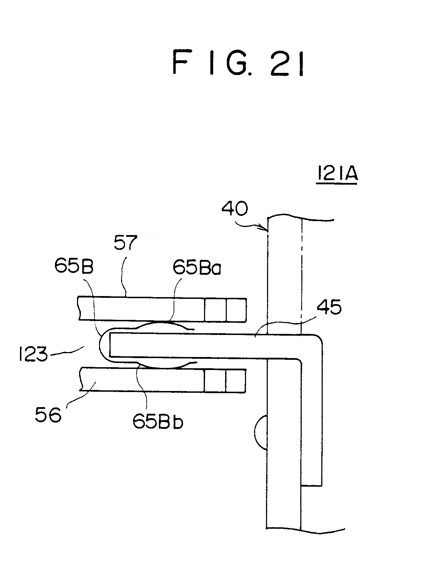

An example of a shielding construction 121A obtained as a result of modifying the shielding construction 121 shown in FIG.16 will now be described with reference to FIG.21. In this example, instead of mounting the relevant leaf-spring member 65 on the top plate 56 of a top electronic circuit block and the bottom plate 57 of a bottom electronic circuit block, a leaf-spring member 65B is mounted on the bracket member 45. The two shielding constructions 121 and 121A have similar effects. The leaf-spring member 65B has two arc-shaped leaf-spring portions 65Ba and 65Bb therein at opposite sides of the bracket member 45 as shown in FIG.21.

Further, the blank block 37 described above is not limited to being located to the position shown in FIG.3 and 4. Instead, since the blank block 37 is used to fill a blank space formed between electronic circuit blocks, the blank block 37 can be mounted at any appropriate position.

Further, the present invention is not limited to the above described embodiments, and variations and modifications may be made without departing from the scope of the present invention as defined by the appended claims.

## Claims

1. A rack apparatus comprising a plurality of metallic containers, each container containing electric components and having side walls, and a holding member made of iron for holding said plurality of containers, wherein said holding member (31) comprises overlaying portions (41b-1, 41c-1) with which said side walls (54, 55) of each container (34, 35, 36) are overlaid, and either said overlaying portions (41b-1, 41c-1) or said plurality of containers (34, 35, 36) comprise an elastic member (65) for elastically pressing the others of said overlaying portions and said plurality of containers.

2. The rack apparatus according to claim 1, characterized in that said elastic member (65) comprises an electrically conductive leaf spring (65b).

3. The rack apparatus according to claim 2, characterized in that said leaf spring (65b) comprises a plurality of leaf-spring elements, each element being curved and said plurality of leaf-spring elements being arranged with one another in a row.

4. The rack apparatus according to any preceding claim,
characterized in that:
said holding member (31) comprises a vertically standing grounded column containing electric cables; and
each of said plurality of containers has a box shape and said plurality of containers being arranged in one row along said holding member, said electric components comprising electronic circuits loaded on printed circuit boards (51).

5. The rack apparatus according to any preceding claim,
characterized in that said holding member (31) comprises a body (40) having said plurality of containers (34, 35, 36) mounted thereon and a covering member (41) for covering said body.

6. The rack apparatus according to claim 5,
characterized in that said holding member (31) further comprises supporting attachments (42) fixed on said body (40) for supporting said overlaying portions (41b-1, 41c-1).

7. The rack apparatus according to any preceding claim,
characterized in that said holding member (31) is formed of a single piece off material.

8. The rack apparatus according to any preceding claim,
characterized in that:
said holding member (31) has brackets (45) projecting therefrom; and
said plurality of containers (34, 35, 36) are mounted on said holding member so that adjacent containers sandwich each of the brackets.

9. The rack apparatus according to claim 8,
characterized in that:
said holding member (31) comprises a vertically standing grounded column containing electric cables; and
each of said plurality of containers (34, 35, 36) has a box shape and said plurality of containers being arranged with one another in one row along said holding member, said electric components comprising electronic circuits loaded on printed circuit boards (51).

10. The rack apparatus according to claim 8,
characterized in that either said brackets (45) or said plurality of containers (34, 35, 36) comprise an elastic member (65) for elastically pressing the others of said brackets and said plurality of containers.

11. The rack apparatus according to claim 10,
characterized in that said elastic member (65) comprises an electrically conductive leaf spring (65b).

12. The rack apparatus according to claim 11,
characterized in that said leaf spring (65b) comprises a plurality of leaf-spring elements, each element being curved and said plurality of leaf-spring elements being arranged in a row.

13. The rack apparatus according to claim 1,
characterized in that:
each of said plurality of containers (34, 35, 36) has a box form including a body (52) and a lid (53), either said body or said lid having an elastic member (65, 65A) for elastically pressing the other of said body and said lid.

14. The rack apparatus according to claim 13, characterized in that said elastic member (65, 65A) comprises an electrically conductive leaf spring.

15. The rack apparatus according to claim 14, characterized in that said leaf spring (65, 67A) comprises a plurality of leaf-spring elements, each element being curved and said plurality of leaf-spring elements being arranged in a row.

16. A rack apparatus according to any one of claims 1 to 15, characterized in that either said holding member (31) or said plurality of containers (34, 35, 36) further comprise an elastic member (65) for elastically pressing the others of said holding member and said plurality of containers.

17. A rack apparatus according to any one of claims 1 to 16, characterized in that said rack apparatus further comprises a blank container (37) for filling a space formed adjacent to one of said plurality of containers (34, 35, 36).

## Patentansprüche

1. Gestellaufbau, umfassend mehrere metallische Container, wobei jeder Container elektrische Komponenten enthält und Seitenwände aufweist, und ein aus Eisen bestehendes Halteglied zum Halten der Container, wobei das Halteglied (31) überlappende Bereiche (41b-1, 41c-1) aufweist, mit denen die Seitenwände (54, 55) jedes Containers (34, 35, 36) überlappt sind, und wobei entweder die überlappenden Bereiche (41b-1, 41c-1) oder die Container (34, 35, 36) ein elastisches Glied (65) umfassen, um die übrigen überlappenden Bereiche und die Container elastisch zu verpressen.

2. Gestellaufbau nach Anspruch 1, dadurch gekennzeichnet, dass das elastische Glied (65) eine elektrisch leitfähige Blattfeder umfasst (65b).

3. Gestellaufbau nach Anspruch 2, dadurch gekennzeichnet, dass die Blattfeder (65b) mehrere Blattfederelemente umfasst, wobei jedes Element gekrümmt ist und die Blattfederelemente zueinander in einer Reihe angeordnet sind.

4. Gestellaufbau nach einem der vorangegangenen Ansprüche, dadurch gekennzeichnet, dass:
das Halteglied (31) eine vertikal stehende, geerdete Säule umfasst, die elektrische Kabel enthält; und
jeder der Container eine Kastenform aufweist und die Container in einer Reihe entlang des Haltegliedes angeordnet sind, wobei die elektrischen Komponenten elektrische Schaltkreise umfassen, die auf gedruckten Schaltplatten (51) aufgebracht sind.

5. Gestellaufbau nach einem der vorangegangenen Ansprüche, dadurch gekennzeichnet, dass das Halteglied (31) einen Rumpf (40) umfasst, auf dem die Container (34, 35, 36) montiert sind, und ein Abdeckglied (41) zum Abdecken des Rumpfes.

6. Gestellaufbau nach Anspruch 5, dadurch gekennzeichnet, dass das Halteglied (31) weiterhin auf dem Rumpf (40) befestigte Stützbefestigungen (42) zum Abstützen der überlappenden Bereiche (41b-1, 41c-1) aufweist.

7. Gestellaufbau nach einem der vorangegangenen Ansprüche, dadurch gekennzeichnet, dass das Halteglied (31) aus einem einzigen Materialstück ausgebildet ist.

8. Gestellaufbau nach einem der vorangegangenen Ansprüche, dadurch gekennzeichnet, dass:
das Halteglied (31) davon abstehende Klammern (45) aufweist; und
die Container (34, 35, 36) auf dem Halteglied derart befestigt sind, dass angrenzende Container jede der Klammern einschließen.

9. Gestellaufbau nach Anspruch 8, dadurch gekennzeichnet, dass:
das Halteglied (31) eine vertikal stehende, geerdete Säule umfasst, die elektrische Kabel enthält; und
jeder der Container eine Kastenform aufweist und die Container in einer Reihe entlang des Haltegliedes angeordnet sind, wobei die elektrischen Komponenten elektrische Schaltkreise umfassen, die auf gedruckten Schaltplatten (51) aufgebracht sind.

10. Gestellaufbau nach Anspruch 8, dadurch gekennzeichnet, dass entweder die Klammern (45) oder die Container (34, 35, 36) ein elastisches Glied (65) umfassen, um die übrigen Klammern und die Container elastisch zu verpressen.

11. Gestellaufbau nach Anspruch 10, dadurch gekennzeichnet, dass das elastische Glied (65) eine elektrisch leitfähige Blattfeder umfasst (65b).

12. Gestellaufbau nach Anspruch 11, dadurch gekennzeichnet, dass die Blattfeder (65b) mehrere Blattfederelemente umfasst, wobei jedes Element gekrümmt ist und die Blattfederelemente zueinander in einer Reihe angeordnet sind.

13. Gestellaufbau nach Anspruch 1, dadurch gekennzeichnet, dass:
jeder der Container (34, 35, 36) eine Kastenform mit einem Rumpf (52) und mit einem Deckel (53) aufweist, wobei entweder der Rumpf oder der Deckel ein elastisches Glied (65, 65A) umfasst, um die übrigen Rümpfe und Deckel elastisch zu verpressen.

14. Gestellaufbau nach Anspruch 13, dadurch gekennzeichnet, dass das elastische Glied (65, 65A) eine elektrisch leitfähige Blattfeder umfasst.

15. Gestellaufbau nach Anspruch 14, dadurch gekennzeichnet, dass die Blattfeder (65, 67A) mehrere Blattfederelemente umfasst, wobei jedes Element gekrümmt ist und die Blattfederelemente zueinander in einer Reihe angeordnet sind.

16. Gestellaufbau nach einem der Ansprüche 1 bis 15, dadurch gekennzeichnet, dass entweder das Halteglied (31) oder die Container (34, 35, 36) ein elastisches Glied (65) umfassen, um die übrigen Halteglieder und die Container elastisch zu verpressen.

17. Gestellaufbau nach einem der Ansprüche 1 bis 16, dadurch gekennzeichnet, dass der Gestellaufbau weiterhin einen Leercontainer (37) aufweist, um einen zu den Containern (34, 35, 36) angrenzenden Raum auszufüllen.

## Revendications

1. Appareil à châssis comprenant plusieurs récipients métalliques, chaque récipient contenant des composants électriques et ayant des parois latérales, et un organe de maintien formé de fer et destiné à supporter les récipients, dans lequel l'organe de maintien (31) comporte des parties de superposition (41b-1, 41c-1) qui sont superposées aux parois latérales (54, 55) de chaque récipient (34, 35, 36), et les parties de superposition (41b-1, 41c-1) ou les récipients (34, 35, 36) comportent un organe élastique (65) destiné à repousser élastiquement les récipients ou les parties de superposition respectivement.

2. Appareil à châssis selon la revendication 1, caractérisé en ce que l'organe élastique (65) comporte un ressort à lame conducteur de l'électricité (65b).

3. Appareil à châssis selon la revendication 2, caractérisé en ce que le ressort à lame (65b) comporte plusieurs éléments de ressort à lame, chaque élément étant courbe et plusieurs éléments de ressort à lame étant disposés en ligne les uns avec les autres.

4. Appareil à châssis selon l'une quelconque des revendications précédentes, caractérisé en ce que :
l'organe de maintien (31) comporte une colonne verticale à la masse contenant des câbles électriques, et
chacun des récipients a une forme de caisson et les récipients sont placés en ligne le long de l'organe de maintien, les composants électriques comprenant des circuits électroniques placés sur des cartes de circuit imprimé (51).

5. Appareil à châssis selon l'une quelconque des revendications précédentes, caractérisé en ce que l'organe de maintien (31) est un corps (40) ayant plusieurs récipients (34, 35, 36) montés sur lui et un organe (41) de recouvrement du corps.

6. Appareil à châssis selon la revendication 5, caractérisé en ce que l'organe de maintien (31) comporte en outre des organes de fixation de support (42) fixés au corps (40) et destinés à supporter les parties de superposition (41b-1, 41c-1).

7. Appareil à châssis selon l'une quelconque des revendications précédentes, caractérisé en ce que l'organe de maintien (31) est formé en une seule pièce d'un matériau.

8. Appareil à châssis selon l'une quelconque des revendications précédentes, caractérisé en ce que :
l'organe de maintien (31) possède des équerres (45) qui dépassent, et
les récipients (34, 35, 36) sont montés sur l'organe de maintien afin que des récipients adjacents entourent chacune des équerres.

9. Appareil à châssis selon la revendication 8, caractérisé en ce que :
l'organe de maintien (31) comporte une colonne verticale mise à la masse et contenant des câbles électriques, et
chacun des récipients (34, 35, 36) a une forme de caisson et les récipients sont disposés en ligne les uns avec les autres le long de l'organe de maintien, les composants électriques comprenant des circuits électroniques placés sur des cartes de circuit imprimé (51).

10. Appareil à châssis selon la revendication 8, caractérisé en ce que les équerres (45) ou les récipients (34, 35, 36) comporte un organe élastique (65) destiné à repousser élastiquement les récipients ou les équerres respectivement.

11. Appareil à châssis selon la revendication 10, caractérisé en ce que l'organe élastique (65) est un ressort à lame conducteur de l'électricité (65b).

12. Appareil à châssis selon la revendication 11, caractérisé en ce que le ressort à lame (65b) comprend plusieurs éléments de ressort à lame, chaque élément étant courbe et les éléments de ressort à lame étant disposés en ligne.

13. Appareil à châssis selon la revendication 1, caractérisé en ce que chacun des récipients (34, 35, 36) a une forme de caisson comprenant un corps (52) et un couvercle (53), le corps ou le couvercle ayant un organe élastique (65, 65A) destiné à exercer élastiquement une pression contre le couvercle ou le corps respectivement.

14. Appareil à châssis selon la revendication 13, caractérisé en ce que l'organe élastique (65, 65A) est un ressort à lame conducteur de l'électricité.

15. Appareil à châssis selon la revendication 14, caractérisé en ce que le ressort à lame (65, 67A) comporte plusieurs éléments de ressort à lame, chaque élément étant courbe et les éléments de ressort à lame étant disposés en ligne.

16. Appareil à châssis selon l'une quelconque des revendications 1 à 15, caractérisé en ce que l'organe de maintien (31) ou les récipients (34, 35, 36) comportent en outre un organe élastique (65) destiné à repousser élastiquement les récipients ou l'organe de maintien respectivement.

17. Appareil à châssis selon l'une quelconque des revendications 1 à 16, caractérisé en ce que l'appareil à châssis comporte en outre un récipient factice (37) destiné à remplir l'espace formé près de l'un des récipients (34, 35, 36).
